# EUROPEAN PATENT SPECIFICATION

(11) **EP 0 246 918 B1**
(45) Date of publication and mention of the grant of the patent: **26.01.1994**
(21) Application number: 87304584.3
(22) Date of filing: 22.05.1987
(51) Int. Cl.: C08C 19/30, C08F 8/46, G03F 7/004

(54) **Curable prepolymers**
Härtbare Polymere
Des prépolymères durcissables

(30) Priority: 23.05.1986 US 866515
(43) Date of publication of application: 25.11.1987
(73) Proprietor: W.R. Grace & Co.-Conn., New York, New York 10036 (US)
(72) Inventor: Klingler, Lori Jane, Columbia Maryland 21044 (US)
(74) Representative: Lawrence, Peter Robin Broughton

(56) References cited:
- FR-A- 2 307 293
- US-A- 4 038 084
- US-A- 4 137 081

## Description

This invention relates to a thermal or radiation curable liquid prepolymer, formulations containing same and processes for using same to form printing plates, coatings, adhesives or sealants. More particularly, this invention is directed to a liquid prepolymer comprising a maleated polymeric hydrocarbon (meth)acrylate, either per se or formulated with mono- or multi-functional unsaturated monomers and either a thermal initiator or photoinitiator which, on exposure to heat or UV or high energy ionizing radiation, forms a thermoset material utilizable as a printing plate, coating, adhesive or sealant.

Photocurable compositions are well known in the art for forming printing plates, coatings, adhesives or sealants. In particular, in the printing plate art, such compositions have made vast inroads in letterpress, offset lithographic and flexographic printing. Initially, the photopolymerizable compositions such as taught in U.S. 2,760,863 required the use of organic solvents for development. However, due to the toxicity, high volatility and low flash point of commercial organic solvents, their use often gave rise to hazardous conditions and created a pollution problem.

Subsequently, U.S. 4,137,081 directed to liquid terminal, olefinic, unsaturated linear polymers in combination with ethylenically unsaturated monomers, a stabilizer and a photoinitiator, resulted in printing plates in which the unirradiated portions can be removed with dilute aqueous solutions of a detergent. However, such materials have a tacky surface which causes the spaces in the relief to fill with ink thereby giving poor printing quality. Japanese 82-967 teaches a polymer image forming process comprising exposing a light sensitive composition prepared from a diene polymer having photopolymerisable unsaturated groups, a photo-polymerisable vinyl monomer, a photoinitiator and, optionally, a thermal polymerisation inhibitor, to UV radiation imagewise and, thereafter, removing the unexposed part of the composition to form a printing plate. The diene monomer such as polybutadiene can have polymerisable unsaturated bonds and be chain extended with epichlorohydrin.

Certain adducts of maleic anhydride and polybutadiene are reacted with a hydroxyalkyl methacrylate in U.S. 4,038,084.

In JP-A-50/059491, a terminal active hydrogen of a diene polymer is reacted with a carboxyl anhydride and a monoepoxy compound to form more than one polyester block at its terminal.

It has been our object to provide improved liquid thermal or radiation curable prepolymers, processes for making them and compositions containing them, especially printing plates, coatings, adhesives and sealants.

A liquid thermal or radiation-curable prepolymer according to the invention has the formula P(X)ₐ, where P is a hydrocarbon polymer residue from a member of the polymeric group consisting of homopolymers of butadiene, isoprene and chloroprene, copolymers of butadiene-acrylonitrile, butadiene-isoprene, butadiene-styrene, ethylene-neohexene, butadiene-acrylic acid, terpolymers of butadiene-acrylonitrile-acrylic acid, and corresponding polymeric hydrogenated group members of all of the above, a is greater than 1, Y is a group attached directly to P and comprises groups having the structure: 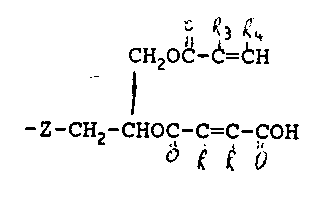
wherein Z is -NR, 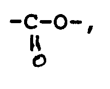
-O- or -S- and R is H or a linear or cyclic alkyl group containing 1-6 carbon atoms, R₁ and R₂ are individually a member of the group consisting of H, halogen, carboxy, linear or cyclic alkyl containing 1 - 2O carbon atoms, aryl, alkaryl and aralkyl containing 6 - 2O carbon atoms; R₃ is H, CH₃ or CH₂COOR₅, R₄ is H, CH₃ or COOR₆, and R₅ and R₆ are H or alkyl having 1 - 2 carbon atoms.

The invention includes processes for forming relief printing plates by coating on to a substrate a layer of a photopolymerisable composition comprising the prepolymer, imagewise exposing the layer to actinic radiation to effect cross linking of the composition in exposed areas, and removing unexposed areas of the composition by washing with an aqueous detergent solution, and the invention also includes photopolymer elements comprising a support and a layer comprising the photopolymer composition, and printing plates obtained by imagewise photocuring of such an element.

The prepolymer is typically formed in a two-step process. In the first step a functionalised liquid hydrocarbon polymer is reacted with a reactant to impart (meth) acrylate groups. Typical functionalised liquid hydrocarbon polymers employed to form the prepolymer of this invention include, but are not limited to, those having backbones of hompolymerised butadiene, isoprene or chloroprene, or copolymerised butadiene-acrylonitrile, butadiene-isoprene, butadiene-styrene or ethylene-neohexene, butadiene-acrylic acid, and terpolymers containing same and containing carboxyl, amine, hydroxyl, thiol, oxirane or aziridine functional groups, or corresponding products from which the olefinic unsaturation has been removed as by hydrogenation. Functional polymers and copolymers of the type useful for preparing these prepolymers include polymers prepared by a free radical polymerization using special catalysts or by anionic polymerization followed by capping the living polymer by carbon dioxide, ethylene oxide, etc., as described in an article by French in Rubber Chemistry and Technology, Vol. 42, pages 71-107 (1969).

More particularly, the first step in the preparation of the prepolymer is carried out by reaction of functional or telechelic polymers of the type described by French in the Rubber Chemistry and Technology article referred to above, in which the terminal functional groups are carboxyl, hydroxyl, thiol or amine groups, with compounds having a functional oxirane or carboxyl group such as glycidyl acrylate, glycidyl methacrylate, glycidyl crotonate, ethyl itaconate monoglycidyl ester or methyl fumarate monoglycidyl ester.

In general, the terminal or pendant olefinically unsaturated polymers obtained in the first step are viscous liquids, having Brookfield viscosities, measured at 25°C, of between 1,000 and 1,000,000 centipoises, most preferably between 20,000 and 100,000 centipoises.

As an illustration of the type of reaction involved to introduce the methacrylate unsaturation into the low molecular weight polymers and copolymers to prepare the first step of the prepolymer useful for this invention, the reaction between a carboxyl terminated polybutadiene and glycidyl methacrylate is represented as follows: 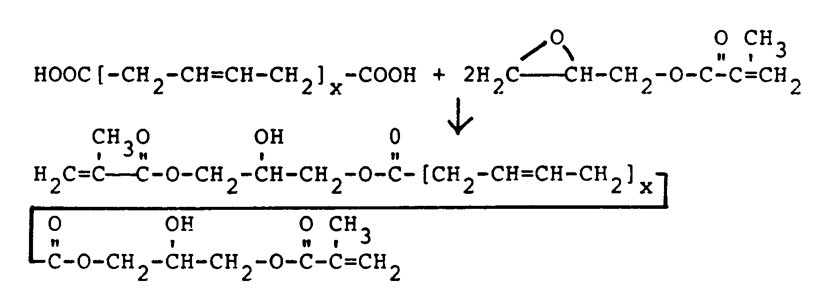
As indicated, two moles of epoxy compound react with each mole of olefin addition polymer. Generally, however, a slight excess of epoxide is used.

Additionally, a greater excess of epoxy compound can be used if additional methacrylate functionality is desired. The excess epoxide reacts with the hydroxyl groups formed by the initial reaction between the functionally terminated olefin addition polymer and the epoxy compound.

These reactions are run at temperatures between 25° and 200°C with a temperature range of 100°-120°C being preferred. An acid or basic catalyst can be used to reduce the required reaction temperature and time. Some useful catalysts are sodium hydroxide, sodium ethoxide, triethylamine, triethylbenzyl ammonium chloride, hydrogen chloride and boron trifluoride etherate. Generally, 0.001 to 5.0% by weight catalyst is used.

An alternative illustration of the first step of the prepolymer synthesis employs an epoxidized polybutadiene, which is reacted with methacrylic acid as follows:

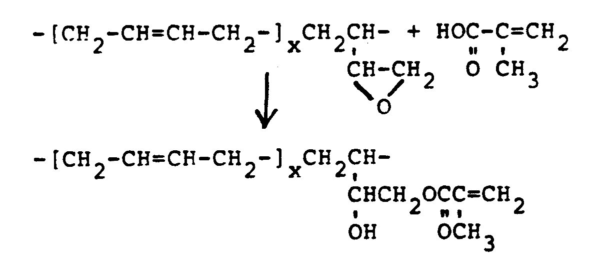

In the second step of the prepolymer synthesis the (meth)acrylate functional liquid hydrocarbon polymer is subjected to maleation. For example, the prepolymer formed in the first illustration supra, now containing hydroxyl groups from the reaction of carboxyl terminated polybutadiene and glycidyl methacrylate, is maleated by reacting the OH groups on said prepolymer with, e.g., maleic anhydride (1 mole per equivalent of OH) resulting in a prepolymer of the general formula: 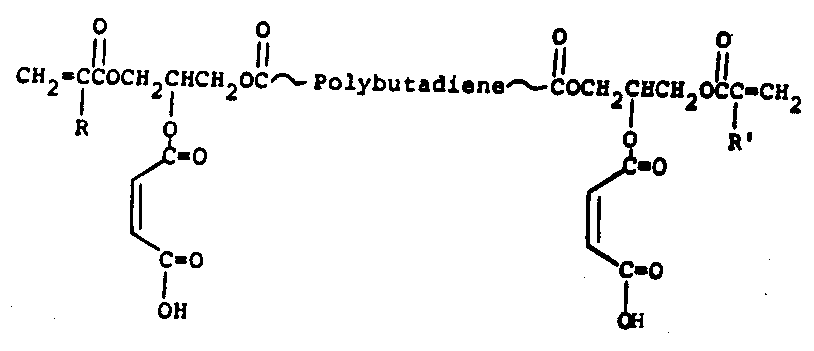
wherein R and R' are CH₃.

Any unsaturated anhydride (i.e., maleic or substituted maleic) of the general formula: 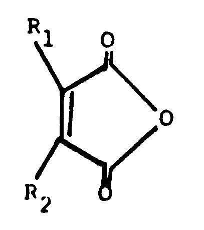
wherein R₁ and R₂ are individually a member of the group consisting of H, halogen, carboxy, linear or cyclic alkyl containing 1-20 carbon atoms, aryl, alkaryl and aralkyl containing 6 to 20 carbon atoms are operable as a reactant with the OH groups on the (meth)acrylate terminated hydrocarbon polymer to form the prepolymer of the instant invention. Additionally, the corresponding unsaturated di-esters and di-acids are also operable as reactants but usually require a longer reaction period. Thus, operable reactants of this type include, but are not limited to, 2,3-diphenylmaleic anhydride, dichloromaleic anhydride, 2,3-dimethylmaleic anhydride, maleic anhydride, bromomaleic anhydride, citraconic anhydride and cis-aconitic anhydride.

The maleation reaction is carried out at a temperature in the range 60-120°C for periods ranging from 4 - 12 hours. The reaction is preferably carried out in the presence of a thermal inhibitor such as di-t-butyl cresol. Although the reaction is preferably formed in the absence of the solvent, inert solvents such as toluene, benzene, chloroform, methylene chloride, tetrahydrofuran, isopropanol, acetone and ethyl acetate can be employed if desired. Although no catalysts are necessary, acids, Lewis acids and bases such as phosphoric acid, stannous octoate and pyridine can be employed. The reactants are usually added in stoichiometric amounts so that one functional group, e.g., a hydroxyl on the polymer of the first step reacts with one maleic anhydride molecule. It is also possible to add an excess of the polycarboxylic acid anhydride.

In a further exemplification of the invention, additional (meth)acrylate and maleate functionality may be added. That is, after the addition of one methacrylate moiety and one maleate moiety as described above, the prepolymer now contains a free carboxyl group. The carboxyl group can be reacted with another molecule of glycidyl (meth)acrylate, thereby generating a free hydroxyl group, which, in turn, can be reacted with another maleic anhydride molecule. The sequence can be repeated ad libitum, to generate a larger number of acrylate and maleate functions, the only limitation being that the final addition be maleate so as to provide free carboxyl functionality in the final prepolymer.

The composition may also contain up to 90% by weight of a reactive, acrylic or methacrylic diluent. This can have the formula: 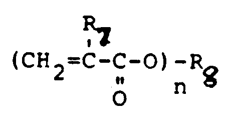
wherein R₇ is H or CH₃ and R₈ is an organic moiety having the valence of n and n is 1 or more. Such reactive acrylic diluents include, but are not limited to, trimethylolpropane triacrylate, hexanediol diacrylate, 1,3-butylene glycol diacrylate, diethylene glycol diacrylate, 1,6-hexanediol diacrylate, neopentyl glycol diacrylate, polyethylene glycol 200 diacrylate, tetraethylene glycol diacrylate, triethylene glycol diacrylate, pentaerythritol tetraacrylate, tripropylene glycol diacrylate, ethoxylated bisphenol-A diacrylate, trimethylolpropane triacrylate, di-trimethylolpropane tetraacrylate, triacrylate of tris(hydroxyethyl) isocyanurate, dipentaerythritol hydroxypentaacrylate, pentaerythritol triacrylate, ethoxylated trimethylolpropane triacrylate, triethylene glycol dimethacrylate, ethylene glycol dimethacrylate, tetraethylene glycol dimethacrylate, polyethylene glycol-200 dimethacrylate, 1,6-hexanediol dimethacrylate, neopentyl glycol dimethacrylate, polyethylene glycol-600 dimethacrylate, 1,3-butylene glycol dimethacrylate, ethoxylated bisphenol-A dimethacrylate, trimethylolpropane trimethacrylate, diethylene glycol dimethacrylate, 1,4-butanediol diacrylate, diethylene glycol dimethacrylate, pentaerythritol tetramethacrylate, glycerin dimethacrylate, trimethylolpropane dimethacrylate, pentaerythritol trimethacrylate, pentaerythritol dimethacrylate, pentaerythritol diacrylate and the like which can be added to the composition to modify the cured product. Monoacrylates such as cyclohexyl acrylate, isobornyl acrylate lauryl acrylate and tetrahydrofurfuryl acrylate and the corresponding methacrylates are also operable as reactive diluents.

In a further aspect of the invention, the prepolymers are cured.

Photoinitiators for the prepolymer and formulations containing same include the benzoin alkyl ethers, such as benzoin methyl ether, benzoin ethyl ether, benzoin isopropyl ether and benzoin isobutyl ether. Another class of photoinitiators are the dialkoxyacetophenones exemplified by 2,2-dimethoxy-2-phenylacetophenone, i.e., "Irgacure® 651" (Ciba-Geigy) and 2,2-diethoxy-2-phenylacetophenone. Still another class of photoinitiators are the aldehyde and ketone carbonyl compounds having at least one aromatic nucleus attached directly to the 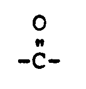
group. These photoinitiators include, but are not limited to, benzophenone, acetophenone, o-methoxybenzophenone, acenapthene-quinone, methyl ethyl ketone, valerophenone, hexanophenone, alpha-phenyl-butyrophenone, p-morpholinopropiophenone, dibenzosuberone, 4-morpholinobenzophenone, 4ʹ-morpholinodeoxybenzoin, p-diacetylbenzene, 4-aminobenzophenone, 4ʹ-methoxyacetophenone, benzaldehyde, alpha-tetralone, 9-acetylphenanthrene, 2-acetylphenanthrene, 10-thioxanthenone, 3-acetyl-phenanthrene, 3-acetylindone, 9-fluorenone, 1-indanone, 1,3,5-triacetylbenzene, thioxanthen-9-one, xanthene-9-one, 7-H-benz[de]anthracen-7-one, 1-naphthaldehyde, 4,4ʹ-bis(dimethylamino)-benzophenone, fluorene-9-one, 1ʹ-acetonaphthone, 2ʹ-acetonaphthone, 2,3-butanedione, acetonaphthone, benz[a]anthracene 7.12 dione, etc. Phosphines such as triphenylphosphine and tri-o-tolylphosphine are also operable herein as photoinitiators. The photoinitiators or mixtures thereof are usually added in an amount ranging from 0.01 to 5% by weight of the total composition.

A class of actinic light useful herein for curing is ultraviolet light and other forms of actinic radiation which are normally found in radiation emitted from the sun or from artificial sources such as Type RS sunlamps, carbon arc lamps, xenon arc lamps, mercury vapor lamps, tungsten halide lamps and the like. Ultraviolet radiation may be used most efficiently if the photocurable composition contains a suitable photoinitiator. Curing periods may be adjusted to be very short and hence commercially economical by proper choice of ultraviolet source, photoinitiator and concentration thereof. Curing periods of about 10 seconds duration are possible, especially in thin film applications such as desired, for example, in coatings. For thicker cured products, curing periods up to 10 minutes, preferably 1-5 minutes, are operable.

When UV radiation is used, an intensity of 0.0004 to 60.0 watts/cm² in the 200-400 nanometer region is usually employed. High energy ionizing radiation can also be used for the curing step without the use of photoinitiators in the instant invention. If high energy ionizing irradiation is used, e.g., electron beam, a dose in the range of 0.01 - 10 megarads is employed at a dose rate of 1.0 x 10⁻⁴ - 4,000 megarads/second. Any radiation having an energy of greater than 3.0 electron volts is operable to cause the curing reaction of the instant invention.

The thermal initiators used herein for curing the prepolymer and formulations containing same are free radical initiators selected from substituted or unsubstituted pinacols, azo compounds, thiurams, organic peroxides and mixtures thereof.

The organic peroxides operable are of the general formula:

R-O-O-(R₁-O-O)ₙ-R

wherein n = O or 1, R is independently selected from hydrogen, aryl, alkyl, aryl carbonyl, alkaryl carbonyl, aralkyl carbonyl and alkyl carbonyl and R₁ is alkyl or aryl, said alkyl groups containing 1 to 20 carbon atoms.

Examples of operable organic peroxides include, but are not limited to 2,5-dimethyl-2,5-di(t-butylperoxy)hexane, 1,3-bis(t-butylperoxyisopropyl)benzene, 1,3-bis-(cumylperoxyisopropyl)benzene, 2,4-dichlorobenzoyl peroxide, caprylyl peroxide, lauroyl peroxide, t-butyl peroxyisobutyrate, benzoyl peroxide, p-chlorobenzoyl peroxide, hydroxyheptyl peroxide, di-t-butyl diperphthalate, t-butyl peracetate, t-butyl perbenzoate, dicumyl peroxide, 1,1-di(t-butylperoxy)-3,3,5-trimethylcyclohexane and di-t-butyl peroxide.

Examples of azo compounds operable herein include, but are not limited to, commercially available compounds such as 2-t-butylazo-2-cyanopropane; 2,2'-azobis-(2,4-dimethyl-4-methoxy-valeronitrile); 2,2'-azobis-(isobutyronitrile); 2,2'-azobis-(2,4-dimethylvaleronitrile) and 1,1'-azobis-(cyclohexanecarbonitrile).

The thiurams operable as thermal initiators herein are of the formula: 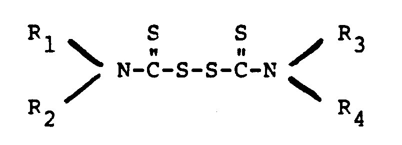
wherein R₁, R₂, R₃ and R₄ taken singly can be hydrogen, linear or branched alkyl having from 1 to about 12 carbon atoms, linear or branched alkenyl having from 2 to about 12 carbon atoms, cycloalkyl having from 3 to about 10 ring carbon atoms, cycloalkenyl having from 3 to about 10 ring carbon atoms, aryl having from 6 to about 12 ring carbon atoms, alkaryl having from 6 to about 12 ring carbon atoms, aralkyl having from 6 to about 12 ring carbon atoms and, when taken together, R₁ and R₂ and R₃ and R₄ can each be a divalent alkylene group (-CₙH₂ₙ-) having from 2 to about 12 carbon atoms, a divalent alkenylene group (-CₙH₂ₙ₋₂-) group having from 3 to about 10 carbon atoms, a divalent alkadienylene group (-CₙH₂ₙ₋₄-) having from 5 to about 10 carbon atoms, a divalent alkatrienylene group (-CₙH₂ₙ₋₆-) having from 5 to about 10 carbon atoms, a divalent alkyleneoxyalkylene group (-CₓH₂ₓOCₓH₂ₓ-) having a total of from 4 to about 12 carbon atoms or a divalent alkyleneaminoalkylene group: 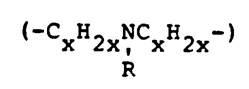
having a total of from 4 to about 12 carbon atoms.

Operable thiurams include, but are not limited to, tetramethylthiuram disulfide, tetraethylthiuram disulfide, di-N-pentamethylenethiuram disulfide, tetrabutylthiuram disulfide, diphenyldimethylthiuram disulfide, diphenyldiethylthiuram disulfide, diethyleneoxythiuram disulfide and the like.

The substituted or unsubstituted pinacols operable herein as a thermal initiator have the general formula: 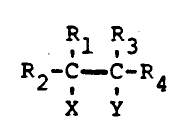
wherein R₁ and R₃ are the same or different substituted or unsubstituted aromatic radicals, R₂ and R₄ are substituted or unsubstituted aliphatic or aromatic radicals and X and Y which may be the same or different are hydroxyl, alkoxy or aryloxy.

Preferred pinacols are those wherein R₁, R₂, R₃ and R₄ are aromatic radicals, especially phenyl radical, and X and Y are hydroxyl.

Examples of this class of compounds include, but are not limited to, benzopinacol, 4,4ʹ-dichlorobenzopinacol, 4,4ʹ-dibromobenzopinacol, 4,4ʹ-diiodobenzopinacol, 4,4ʹ,4ʺ,4‴-tetrachlorobenzopinacol, 2,4-2ʹ,4ʹ-tetrachlorobenzopinacol, 4,4ʹ-dimethylbenzopinacol, 3,3ʹ-dimethylbenzopinacol, 2,2ʹ-dimethylbenzopinacol, 3,4-3ʹ,4ʹ-tetramethylbenzopinacol, 4,4ʹ-dimethoxybenzopinacol, 4,4ʹ,4ʺ,4‴-tetramethoxybenzopinacol, 4,4ʹ-diphenylbenzopinacol, 4,4ʹ-dichloro-4ʺ,4‴-dimethylbenzopinacol, 4,4ʹ-dimethyl-4ʺ,4‴-diphenylbenzopinacol, xanthonpinacol, fluorenonepinacol, acetophenonepinacol, 4,4ʹ-dimethylacetophenone-pinacol, 4,4ʹ-dichloroacetophenonepinacol, 1,1,2-triphenyl-propane-1,2-diol, 1,2,3,4-tetraphenylbutane-2,3-diol, 1,2-diphenylcyclobutane-1,2-diol, propiophenone-pinacol, 4,4ʹ-dimethylpropiophenone-pinacol, 2,2ʹ-ethyl-3,3ʹ-dimethoxypropiophenone-pinacol, 1,1,1,4,4,4-hexafluoro-2,3-diphenyl-butane-2,3-diol.

As further thermal initiators according to the present invention, there may be mentioned:
benzopinacol monomethylether, benzopinacol monophenylether, benzopinacol monoisopropyl ether, benzopinacol monoisobutyl ether, benzopinacol mono (diethoxymethyl) ether and the like.

The thermal initiators or mixtures thereof are usually added in amounts ranging from 0.01 to 10% by weight of the total composition.

The thermal cure is usually carried out at temperatures in the range 80°-150°C. Full cures may require curing periods up to 30 minutes or more.

To inhibit premature crosslinking during thermal processing and storage of the prepolymer containing compositions of this invention, a thermal polymerization inhibitor and stabilizers are added. Such stabilizers also are well known in the art, and include, but are not limited to, di-t-butyl-p-cresol, hydroquinone monomethylether, pyrogallol, quinone, hydroquinone, methylene blue, t-butyl catechol, hydroquinone monobenzyl ether, methyl hydroquinone, amyl quinone, amyloxy hydroquinone, n-butyl phenol, phenol, hydroquinone monopropyl ether, phenothiazine and nitrobenzene, and mixtures thereof. When used in an amount within the range of from about 0.01 to about 2% by weight of the prepolymer, these stabilizers are quite effective in preventing crosslinking of the photopolymer composition during processing and storage.

When the prepolymer or composition containing same is UV cured, the compositions also may contain up to about 50% by weight of an inert particulate filler which is essentially transparent to actinic light. Such fillers include the organophilic silicas, the bentonites, silica and powdered glass, all having a particle size less than 0.4 mil in their maximum dimension. Particles of 0.1 micron or less in size are preferred. Such fillers can impart desirable properties to the compositions and reliefs of this invention.

In instances where compositions containing the prepolymer of the instant invention are cured thermally, then an equal amount of conventional fillers such as graphite can be employed.

According to a further aspect of the invention, photopolymer elements can be formed which comprise a support and a layer comprising photopolymer composition. The photopolymer composition comprises liquid prepolymer and photoinitiator.

The prepolymers of this invention are particularly suitable for application requiring photopolymers that are exposed imagewise (i.e., through a photographic negative) and, subsequently, developed in aqueous medium, for example, for use as a relief printing plate for letterpress or flexographic printing.

When the prepolymer compositions of this invention are exposed imagewise through a photographic transparency to actinic light at a wave length of from about 200 to about 400 nanometers, the composition beneath the exposed areas becomes insolubilized, whereas the polymer beneath the unexposed areas remains water dispersible. Subsequent washing of the plate removes the dispersible polymer, leaving a replica of the photographic transparency in relief. Washing will normally be carried out with dilute aqueous solution of an anionic or nonionic detergent. Anionic detergents such as alpha-olefin sulfonates, alkylaryl sulfonates, lauryl sulfate, alkyl esters of sulfosuccinic acid, or sulfated ethylene oxide condensates of alkyl phenols or fatty alcohols, and nonionic detergents such as alkyl phenol, fatty alcohol or fatty acid ethylene oxide condensates may be used. Alpha-olefin sulfonates are particularly useful. Detergent concentrations of about 0.2 to 2% will normally be employed, generally at temperatures of 25°-60°C. Development may frequently be accelerated by brushing or scrubbing. In large scale work, application of the water solvent will advantageously be carried out by means of jets or sprays. In some instances, it may be helpful to use minor quantities of organic solvents such as the short chain aliphatic alcohols and ketones. Suitable solvents of these types include methanol, ethanol and acetone, and they generally will be used in amounts no greater than 25-35%, preferably less than 1-5% of the water or aqueous detergent developer. Following development of the plate, residual surface water, and any organic solvent which might be present, may be removed by passing a current of warm air over the relief. In some instances it may be desirable to post-expose or post-cure the plates by exposing to actinic light at the wave lengths recited above, after the uncrosslinked photopolymer composition has been washed away.

Printing plates made in accordance with this invention exhibit superior washout of the uncured polymer and notable absence of tack on the surfaces of the cured polymer as compared to plates made in a similar manner from formulations containing analogous prepolymers having only (meth)acrylate functionality and no maleate functionality. Nevertheless, the cured polymer of the present invention exhibits resistance to swelling in water, alcohol and alcohol/acetate solvents used in typical printing inks that is comparable to the swelling resistance of cured formulations containing prepolymer having only (meth)acrylate functionality.

The following examples will aid in explaining, but expressly not limit, the instant invention. Unless otherwise noted, all parts and percentages are by weight. For purposes of illustration, the liquid hydrocarbon polymer used in the examples will be a carboxyl terminated polybutadiene.

### Example 1 (Comparative)

454 g of a commercially available polybutadiene having 1.9 terminal carboxylic acid groups per molecule and an average molecular weight of 4,200 (Goodrich CTB 2000x162) was reacted with 27.9 g of glycidyl methacrylate in the presence of 0.8% sodium methoxide, 0.2% of 2,6-di-t-butyl-4-methylphenol and 0.005% of nitrobenzene at 100°C for 17 hours at which time the acid functionality was determined to be less than 0.05 meq/g by titration. The resulting polymer, i.e., 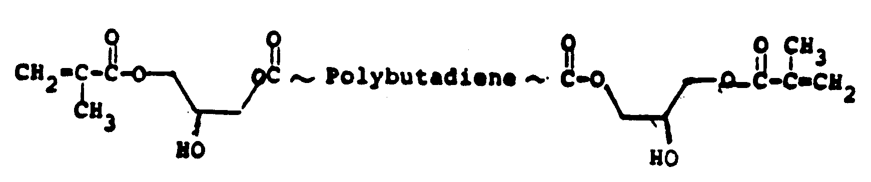
was blended with 2% Irgacure-651 (a Ciba-Geigy tradename) and a 20 mil thick sample was irradiated at 11 mW/cm² between sheets of Mylar for 4 minutes. The cured material was characterized by a tensile of 236 psi, modulus of 388 psi, elongation of 127%, Shore A of 54 and resilience of 50%.

### Example 2

The polybutadiene methacrylate described in Example 1 was reacted with 19.1 g of maleic anhydride at 70°C for 6 hours or until maleic anhydride was determined to be gone by infrared analysis. The resulting maleated polybutadiene methacrylate prepolymer, i.e., 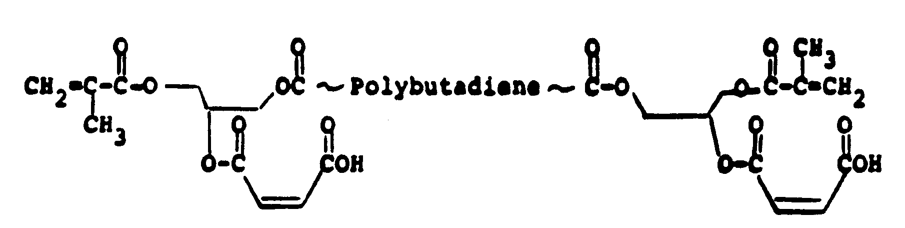
was blended with 2% Irgacure-651 and irradiated as described in Example 1 to give a cured material characterized by a tensile of 334 psi, modulus of 818 psi, elongation of 72%, Shore A of 69 and resilience of 58%.

### Example 3 (Comparative)

400 g of the polybutadiene methacrylate described in Example 1 was blended with 40 g of lauryl methacrylate, 91 g of isobornyl methacrylate and 3 g of Irgacure-651 to give a composition with a viscosity of 55,000 cp at 25°C. A 110 mil thick sample was imaged through a negative, developed in aqueous detergent (1% solution of Stepan Bioterge AS-40) and post-exposed under water to give a relief printing plate which was characterized by a moderately clean, although textured floor and a tacky surface.

### Example 4

400 g of the maleated polybutadiene methacrylate described in Example 2 was formulated exactly as described in Example 3 to give a composition with a viscosity of 41,000 cp at 25°C. A 110 mil thick sample was imaged, developed and post-exposed as described in Example 3 to give a relief printing plate which was characterized by a smoother floor with superior washout compared with that described in Example 3. The surface of the floor was entirely tack-free.

### Example 5

To make a printing plate for flexographic printing, a photographic negative was placed on the lower glass plate of a commercial type exposure unit and covered with a polypropylene cover sheet. The following polymer formulation was applied to the polypropylene cover sheet to a depth of 110 mils:
75.0 parts prepolymer from Example 2
7.5 parts lauryl methacrylate
17.0 parts isobornyl methacrylate
0.5 parts 2,2-dimethoxy-2-phenylacetophenone.
The applied formulation was covered with a 5-mil Mylar backing sheet. To provide a base or floor, the polymer was exposed through the Mylar backing to a bank of UV lights (2.6 mW/cm²) for 70 seconds. It was subsequently exposed imagewise through the negative to a bank of UV lights (3.6 mW/cm²) for 5 minutes. The thus exposed plate was stripped of its cover sheet and developed in a commercial type rotary wash-out unit with a spray of aqueous detergent solution containing 1.0% of a 40% solution of a sodium alpha-olefin sulfonate (sold by Stepan Chemicals as Bioterge AS-40) and 0.3% of a 15% silicone defoamer emulsion (sold as Defoamer H-10 by Dow-Corning). After washing, the plate was post-exposed under water to a fluorescent lamp for 10 minutes to cure any residual unexposed polymer.

## Claims (Claims for the following Contracting State(s): AT, BE, CH, DE, FR, GB, GR, IT, LI, LU, NL, SE)

1. A liquid thermal or radiation curable prepolymer having the formula P(Y)ₐ, where P is a hydrocarbon polymer residue from a member of the polymeric group consisting of homopolymers of butadiene, isoprene and chloroprene, copolymers of butadiene-acrylonitrile, butadiene-isoprene, butadiene-styrene, ethylene-neohexene, butadiene-acrylic acid, terpolymers of butadiene-acrylonitrile-acrylic acid, and corresponding polymeric hydrogenated group members of all of the above, a is greater than 1, Y is a group attached directly to P and comprises groups having the structure: 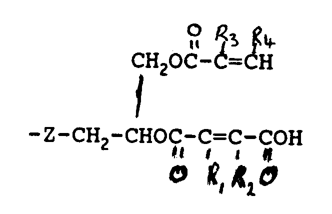 wherein Z is -NR, 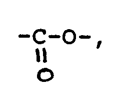 -O- or -S- and R is H or a linear or cyclic alkyl group containing 1-6 carbon atoms, R₁ and R₂ are individually a member of the group consisting of H, halogen, carboxy, linear or cyclic alkyl containing 1 - 20 carbon atoms, aryl, alkaryl and aralkyl containing 6 - 20 carbon atoms; R₃ is H, CH₃ or CH₂COOR₅, R₄ is H, CH₃ or COOR₆, and R₅ and R₆ are H or alkyl having 1 - 2 carbon atoms.

2. A prepolymer according to claim 1 which is obtained by the reaction of carboxyl terminal groups on said hydrocarbon polymer with glycidyl (meth) acrylate to obtain a (meth) acrylate terminated polymeric hydrocarbon intermediate having pendant hydroxyl groups and reacting said pendant groups with maleic anhydride.

3. A prepolymer according to claim 1 having the formula 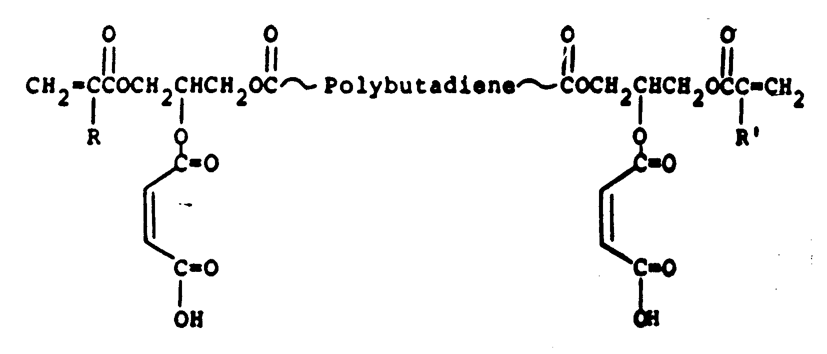 wherein R and R' are each CH₃.

4. A photopolymer composition comprising a liquid prepolymer and 0.01 to 5% of weight of a photoinitiator, characterised in that the prepolymer is a polymer according to any of claims 1 to 3.

5. A composition according to claim 4 containing in addition up to 90% by weight of a reactive acrylic or methacrylic diluent.

6. A composition according to claim 4 or claim 5 which contains up to 50% by weight of an inert transparent filler.

7. A photopolymer element comprising a support and a layer comprising a photopolymer composition, characterised in that the composition is a composition according to claim 4, claim 5 or claim 6.

8. A heat curable composition comprising a liquid prepolymer and a thermal initiator characterised in that the prepolymer is a polymer according to any of claims 1 to 3.

9. A composition according to claim 8 containing in addition up to 90% by weight of a reactive acrylic or methacrylic diluent.

10. A composition according to claim 8 or claim 9 containing in addition up to 50% by weight of an inert filler.

11. A product comprising a cured prepolymer according to any of claims 1 to 3.

12. A printing plate obtained by imagewise photocuring an element according to claim 7.

13. A process of forming a maleated polymeric hydrocarbon (meth) acrylate which comprises forming a polymeric hydrocarbon (meth) acrylate by reacting a polymer selected from homopolymers of butadiene, isoprene and chloroprene, copolymers of butadiene-acrylonitrile, butadiene-isoprene, butadiene-styrene, ethylene-neohexene, butadiene-acrylic acid, terpolymers of butadiene-acrylonitrile-acrylic acid, and corresponding polymeric hydrogenated group members of all of the above, said polymeric group members containing terminal functional group members selected from the group consisting of carboxyl, amine, hydroxyl, thiol and oxirane, with a functionalized (meth) acrylic containing compound, the functionality on said compound being a member of the group consisting of carboxyl and oxirane and being reactive with the terminal functional group members on said polymeric group member, said reaction being carried out at a temperature in the range 25 - 200°C to provide a (meth) acrylate terminated polymeric hydrocarbon having pendant hydroxyl groups and, thereafter, reacting said pendant hydroxyl groups on said polymeric hydrocarbon (meth) acrylate with a member of the group consisting of an unsaturated anhydride of the general formula: 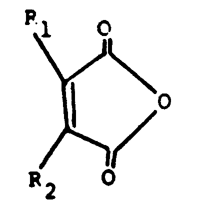 wherein R₁ and R₂ are individually a member of the group consisting of H, halogen, carboxyl, linear or cyclic alkyl containing 1-20 carbon atoms, aryl, alkaryl and aralkyl containing 6 to 20 carbon atoms and the corresponding di-esters and di-acids at a temperature of from 60 to 120°C to form the maleated polymeric hydrocarbon (meth) acrylate.

14. A process according to claim 13 wherein the polymer comprises carboxyl-containing polybutadiene, the functionalised (meth) acrylic containing compound is glycidyl methacrylate and the unsaturated anhydride is maleic anhydride.

15. A process according to claim 13 wherein the polymer comprises epoxidised polybutadiene, the functionalised (meth) acrylic containing compound is methacrylic acid and the unsaturated anhydride is maleic anhydride.

16. A process of forming a relief printing plate comprising the steps of (a) coating on to a substrate a layer of a photopolymerisable composition according to any of claims 4 to 6, imagewise exposing the layer to actinic radiation to effect cross linking of the composition in exposed areas, and (c) removing unexposed areas of the composition by washing with an aqueous detergent solution.

17. A process according to claim 16 further comprising post-exposing the relief printing plate to actinic radiation after the washing.

## Claims (Claims for the following Contracting State(s): ES)

1. A process for preparing a liquid thermal or radiation curable prepolymer having the formula P(Y)ₐ, where P is a hydrocarbon polymer residue from a member of the polymeric group consisting of homopolymers of butadiene, isoprene and chloroprene, copolymers of butadiene-acrylonitrile, butadiene-isoprene, butadiene-styrene, ethylene-neohexene, butadiene-acrylic acid, terpolymers of butadiene-acrylonitrile-acrylic acid, and corresponding polymeric hydrogenated group members of all of the above, a is greater than 1, Y is a group attached directly to P and comprises groups having the structure: 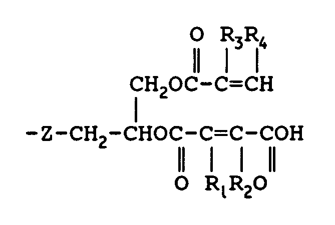 wherein Z is -NR, 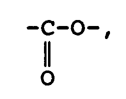 -O- or -S- and R is H or a linear or cyclic alkyl group containing 1-6 carbon atoms, R₁ and R₂ are individually a member of the group consisting of H, halogen, carboxy, linear or cyclic alkyl containing 1 - 20 carbon atoms, aryl, alkaryl and aralkyl containing 6 - 20 carbon atoms; R₃ is H, CH₃ or CH₂COOR₅, R₄ is H, CH₃ or COOR₆, and R₅ and R₆ are H or alkyl having 1 - 2 carbon atoms comprising a first step in which a functionalised liquid hydrocarbon polymer is reacted with a reactant to impart (meth) acrylate groups and a second step in which the (meth)acrylate functionalised liquid hydrocarbon polymer is subjected to maleation by reaction with a maleating agent.

2. A process according to claim 1 which comprises forming a polymeric hydrocarbon (meth) acrylate by reacting a polymer selected from homopolymers of butadiene, isoprene and chloroprene, copolymers of butadiene-acrylonitrile, butadiene-isoprene, butadiene-styrene, ethylene-neohexene, butadiene-acrylic acid, terpolymers of butadiene-acrylonitrile-acrylic acid, and corresponding polymeric hydrogenated group members of all of the above, said polymeric group members containing terminal functional group members selected from the group consisting of carboxyl, amine, hydroxyl, thiol and oxirane, with a reactant which is a functionalized (meth) acrylic containing compound, the functionality on said compound being a member of the group consisting of carboxyl and oxirane and said compound being reactive with the terminal functional group members on said polymeric group member, said reaction being carried out at a temperature in the range 25 - 200°C to provide a (meth) acrylate terminated polymeric hydrocarbon having pendant hydroxyl groups and, thereafter, reacting said pendant hydroxyl groups on said polymeric hydrocarbon (meth) acrylate with a maleating agent which is a member of the group consisting of an unsaturated anhydride of the general formula: 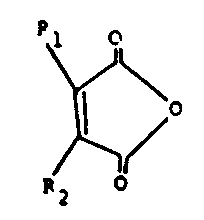 wherein R₁ and R₂ are individually a member of the group consisting of H, halogen, carboxyl, linear or cyclic alkyl containing 1-20 carbon atoms, aryl, alkaryl and aralkyl containing 6 to 20 carbon atoms and the corresponding di-esters and di-acids at a temperature of from 60 to 120°C to form the maleated polymeric hydrocarbon (meth) acrylate.

3. A process according to claim 1 or claim 2 wherein the polymer comprises carboxyl-containing polybutadiene, the reactant is glycidyl methacrylate and the maleating agent is maleic anhydride.

4. A process according to claim 1 or claim 2 wherein the polymer comprises epoxidised polybutadiene, the reactant is methacrylic acid and the maleating agent is maleic anhydride.

5. A process according to claim 1 in which the prepolymer produced has the formula 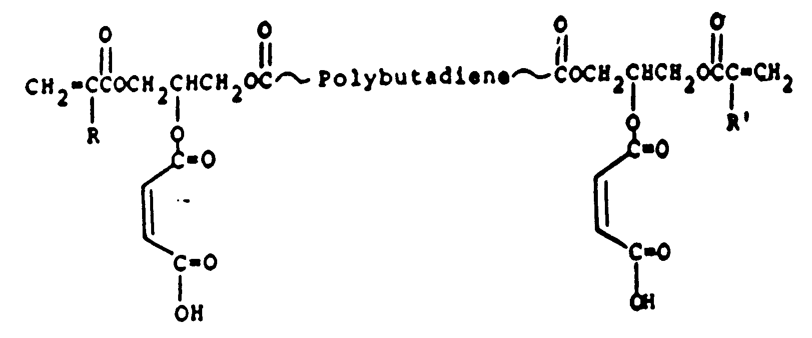 wherein R and R' are each CH₃.

6. A process comprising providing a photopolymer composition comprising a liquid prepolymer and 0.01 to 5% by weight of a photoinitiator, characterised in that the prepolymer is prepared by a process according to any of claims 1 to 5.

7. A process according to claim 6 comprising providing a composition containing in addition up to 90% by weight of a reactive acrylic or methacrylic diluent.

8. A process according to claim 6 or claim 7 comprising providing a composition containing up to 50% by weight of an inert transparent filler.

9. A process for forming a photopolymer element comprising a support and a layer comprising a photopolymer composition, the process comprising providing a composition according to claim 6, claim 7 or claim 8 and applying a layer of the composition onto the support.

10. A process for preparing a heat curable composition comprising providing a composition comprising a liquid prepolymer prepared by a process according to any of claims 1 to 5 and a thermal initiator.

11. A process according to claim 10 comprising providing a composition containing in addition up to 90% by weight of a reactive acrylic or methacrylic diluent.

12. A process according to claim 10 or claim 11 comprising providing a composition containing in addition up to 50% by weight of an inert filler.

13. A process according to any of claims 1 to 5 comprising the additional step of curing the polymer.

14. A process of forming a relief printing plate comprising the steps of (a) coating on to a substrate a layer of a photopolymerisable composition formed according to any of claims 6 to 8, imagewise exposing the layer to actinic radiation to effect cross linking of the composition in exposed areas, and (c) removing unexposed areas of the composition by washing with an aqueous detergent solution.

15. A process according to claim 14 further comprising post-exposing the relief printing plate to actinic radiation after the washing.

## Patentansprüche (Patentansprüche für folgende(n) Vertragsstaat(en): AT, BE, CH, DE, FR, GB, GR, IT, LI, LU, NL, SE)

1. Flüssiges, thermisch oder durch Strahlung härtbares Prepolymer mit der Formel P(Y)ₐ, wobei P ein Kohlenwasserstoffpolymerrest von einem Mitglied der Polymergruppe bestehend aus Homopolymeren von Butadien, Isopren und Chloropren, Copolymeren aus Butadien-Acrylnitril, Butadien-Isopren, Butadien-Styrol, Ethylen-Neohexen, Butadien-Acrylsäure, Terpolymeren aus Butadien-Acrylnitril-Acrylsäure, sowie den entsprechenden hydrierten Polymergruppenmitglieder von allen zuvor genannten ist, a größer als 1 ist und Y eine Gruppe ist, die direkt an P gebunden ist und Gruppen mit der Struktur 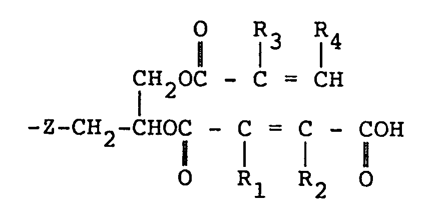 umfaßt, wobei Z -NR, 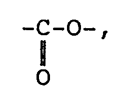 -O- oder -S- ist und R H oder eine lineare oder cyclische Alkylgruppe mit 1 bis 6 Kohlenstoffatomen ist, R₁ und R₂ individuell ein Mitglied der Gruppe bestehend aus H, Halogen, Carboxy, linearem oder cyclischem Alkyl mit 1 bis 20 Kohlenstoffatomen, Aryl, Alkaryl und Aralkyl mit 6 bis 20 Kohlenstoffatomen sind, R₃ H, CH₃ oder CH₂COOR₅ ist, R₄ H, CH₃ oder COOR₆ ist und R₅ und R₆ H oder Alkyl mit 1 bis 2 Kohlenstoffatomen sind.

2. Prepolymer nach Anspruch 1, das durch die Umsetzung von endständigen Carboxylgruppen an dem Kohlenwasserstoffpolymer mit Glycidyl(meth)acrylat, um eine Polymerkohlenwasserstoffzwischenstufe mit endständigem (Meth)acrylat und Hydroxylseitengruppen zu erhalten, und Umsetzung der Seitengruppen mit Maleinsäureanhydrid erhalten worden ist.

3. Prepolymer nach Anspruch 1 mit der Formel 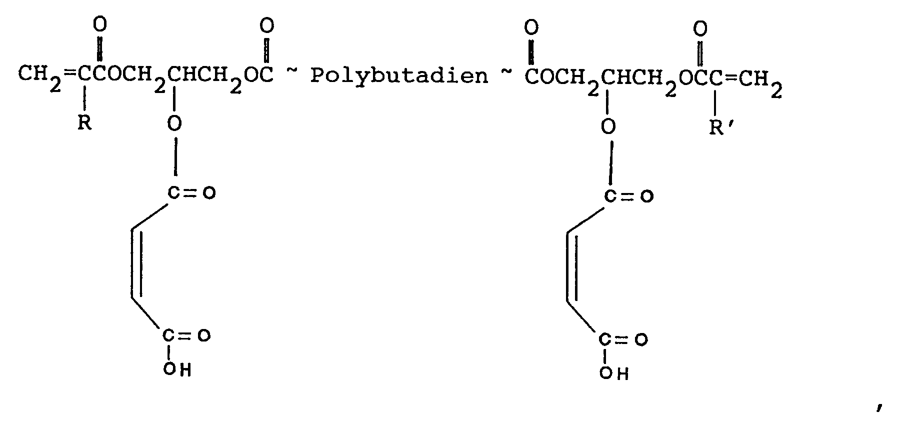 wobei R und R' jeweils CH₃ sind.

4. Photopolymerzusammensetzung, die ein flüssiges Prepolymer und 0,01 bis 5 Gew.% eines Photoinitiators umfaßt, dadurch gekennzeichnet, daß das Prepolymer ein Polymer gemäß einem der Ansprüche 1 bis 3 ist.

5. Zusammensetzung nach Anspruch 4, die zusätzlich bis zu 90 Gew.% eines reaktiven Acryl- oder Methacrylverdünnungsmittels enthält.

6. Zusammensetzung nach Anspruch 4 oder Anspruch 5, die bis zu 50 Gew.% eines inerten transparenten Füllstoffs enthält.

7. Photopolymerelement, das einen Träger und eine Photopolymerzusammensetzung umfassende Schicht umfaßt, dadurch gekennzeichnet, daß die Zusammensetzung eine Zusammensetzung gemäß Anspruch 4, Anspruch 5 oder Anspruch 6 ist.

8. Durch Wärme härtbare Zusammensetzung, die ein flüssiges Prepolymer und einen Thermoinitiator umfaßt, dadurch gekennzeichnet, daß das Prepolymer ein Polymer gemäß einem der Ansprüche 1 bis 3 ist.

9. Zusammensetzung nach Anspruch 8, die zusätzlich bis zu 90 Gew.% eines reaktiven Acryl- oder Methacrylverdünnungsmittels enthält.

10. Zusammensetzung nach Anspruch 8 oder 9, die zusätzlich bis zu 50 Gew.% eines inerten Füllstoffs enthält.

11. Produkt, das ein gehärtetes Prepolymer nach einem der Ansprüche 1 bis 3 umfaßt.

12. Druckplatte, die durch bildmäßiges Photohärten eines Elements gemäß Anspruch 7 erhalten wird.

13. Verfahren zum Herstellen eines maleierten Polymerkohlenwasserstoff (meth)acrylats, bei dem ein Polymerkohlenwasserstoff(meth)acrylat gebildet wird, indem ein Polymer ausgewählt aus Homopolymeren von Butadien, Isopren und Chloropren, Copolymeren aus Butadien-Acrylnitril, Butadien-Isopren, Butadien-Styrol, Ethylen-Neohexen, Butadien-Acrylsäure, Terpolymeren aus Butadien-Acrylnitril-Acrylsäure, sowie den entsprechenden polymeren hydrierten Gruppenmitglieder von allen zuvor genannten, wobei die Polymergruppenmitglieder endständige funktionelle Gruppen ausgewählt aus der Gruppe bestehend aus Carboxyl, Amin, Hydroxyl, Thiol und Oxiran enthalten, mit einer funktionalisierten (meth)acrylhaltigen Verbindung umgesetzt wird, wobei die Funktionalität der Verbindung ein Mitglied aus der Gruppe bestehend aus Carboxyl und Oxiran ist und reaktiv mit den endständigen funktionellen Gruppenmitgliedern auf dem Polymergruppenmitglied ist, wobei die Reaktion bei einer Temperatur im Bereich von 25 bis 200°C durchgeführt wird, um einen Polymerkohlenwasserstoff mit endständigem (Meth)acrylat und Hydroxylseitengruppen zu liefern, und danach die Hydroxylseitengruppen auf dem Polymerkohlenwasserstoff(meth)acrylat mit einem Mitglied aus der Gruppe bestehend aus einem ungesättigten Anhydrid mit der allgemeinen Formel: 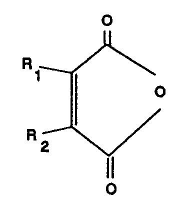 , wobei R₁ und R₂ individuell ein Mitglied der Gruppe bestehend aus H, Halogen, Carboxy, linearem oder cyclischem Alkyl mit 1 bis 20 Kohlenstoffatomen, Aryl, Alkaryl und Aralkyl mit 6 bis 20 Kohlenstoffatomen und den entsprechenden Diestern und Disäuren sind, bei einer Temperatur von 60 bis 120°C umgesetzt werden, um das maleierte Polymerkohlenwasserstoff(meth)acrylat zu liefern.

14. Verfahren nach Anspruch 13, bei dem das Polymer carboxylhaltiges Polybutadien umfaßt, die funktionalisierte (meth)acrylhaltige Verbindung Glycidylmethacrylat ist und das ungesättigte Anhydrid Maleinsäureanhydrid ist.

15. Verfahren nach Anspruch 13, bei dem das Polymer epoxidiertes Polybutadien umfaßt, die funktionalisierte (meth)acrylhaltige Verbindung Methacrylsäure ist und das ungesättigte Anhydrid Maleinsäureanhydrid ist.

16. Verfahren zum Herstellen einer Reliefdruckplatte, bei dem (a) ein Substrat mit einer Schicht aus einer photopolymerisierbaren Zusammensetzung nach einem der Ansprüche 4 bis 6 beschichtet wird, (b) die Schicht bildmäßig aktinischer Strahlung ausgesetzt wird, um eine Vernetzung der Zusammensetzung in den belichteten Gebieten zu bewirken, und (c) nicht belichtete Bereiche der Zusammensetzung durch Waschen mit einer wäßrigen Tensidlösung entfernt werden.

17. Verfahren nach Anspruch 16, bei dem die Reliefdruckplatte nach dem Waschen mit aktinischer Strahlung nachbelichtet wird.

## Patentansprüche (Patentansprüche für folgende(n) Vertragsstaat(en): ES)

1. Verfahren zur Herstellung eines flüssigen, thermisch oder durch Strahlung härtbaren Prepolymers mit der Formel P(Y)ₐ, wobei P ein Kohlenwasserstoffpolymerrest von einem Mitglied der Polymergruppe bestehend aus Homopolymeren von Butadien, Isopren und Chloropren, Copolymeren aus Butadien-Acrylnitril, Butadien-Isopren, Butadien-Styrol, Ethylen-Neohexen, Butadien-Acrylsäure, Terpolymeren aus Butadien-Acrylnitril-Acrylsäure, sowie den entsprechenden hydrierten Polymergruppenmitglieder von allen zuvor genannten ist, a größer als 1 ist und Y eine Gruppe ist, die direkt an P gebunden ist und Gruppen mit der Struktur 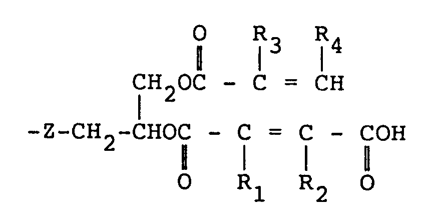 umfaßt, wobei Z -NR, 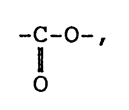 -O- oder -S- ist und R H oder eine lineare oder cyclische Alkylgruppe mit 1 bis 6 Kohlenstoffatomen ist, R₁ und R₂ individuell ein Mitglied der Gruppe bestehend aus H, Halogen, Carboxy, linearem oder cyclischem Alkyl mit 1 bis 20 Kohlenstoffatomen, Aryl, Alkaryl und Aralkyl mit 6 bis 20 Kohlenstoffatomen sind, R₃ H, CH₃ oder CH₂COOR₅ ist, R₄ H, CH₃ oder COOR₆ ist und R₅ und R₆ H oder Alkyl mit 1 bis 2 Kohlenstoffatomen sind, bei dem ein funktionalisiertes flüssiges Kohlenwasserstoffpolymer mit einem Reaktanten umgesetzt wird, um es mit (Meth)acrylatgruppen zu versehen, und in einer zweiten Stufe das mit (Meth)acrylat funktionalisierte flüssige Kohlenwasserstoffpolymer durch Umsetzung mit einem Maleierungsmittel einer Maleierung unterworfen wird.

2. Verfahren nach Anspruch 1, bei dem ein Polymerkohlenwasserstoff (meth)acrylat gebildet wird, indem ein Polymer ausgewählt aus Homopolymeren von Butadien, Isopren und Chloropren, Copolymeren aus Butadien-Acrylnitril, Butadien-Isopren, Butadien-Styrol, Ethylen-Neohexen, Butadien-Acrylsäure, Terpolymeren aus Butadien-Acrylnitril-Acrylsäure, sowie den entsprechenden hydrierten Polymergruppenmitglieder von allen zuvor genannten, wobei die Polymergruppenmitglieder endständige funktionelle Gruppenmitglieder ausgewählt aus der Gruppe bestehend aus Carboxyl, Amin, Hydroxyl, Thiol und Oxiran enthalten, mit einem Reaktanten umgesetztu wird, der eine funktionalisierte (meth)acrylhaltige Verbindung ist, wobei die Funktionalität der Verbindung ein Mitglied aus der Gruppe bestehend aus Carboxyl und Oxiran ist und reaktiv mit den endständigen funktionellen Gruppenmitgliedern auf dem Polymergruppenmitglied ist, wobei die Reaktion bei einer Temperatur im Bereich von 25 bis 200°C durchgeführt wird, um einen Polymerkohlenwasserstoff mit endständigem (Meth)acrylat und Hydroxylseitengruppen zu liefern, und danach die Hydroxylseitengruppen auf dem Polymerkohlenwasserstoff(meth)acrylat mit einem Maleierungsmittel umgesetzt werden, das ein Mitglied aus der Gruppe bestehend aus einem ungesättigten Anhydrid mit der allgemeinen Formel: 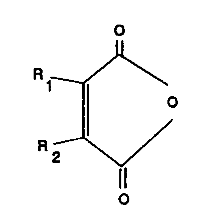 ist, wobei R₁ und R₂ individuell ein Mitglied der Gruppe bestehend aus H, Halogen, Carboxy, linearem oder cyclischem Alkyl mit 1 bis 20 Kohlenstoffatomen, Aryl, Alkaryl und Aralkyl mit 6 bis 20 Kohlenstoffatomen und den entsprechenden Diestern und Disäuren sind, bei einer Temperatur von 60 bis 120°C umgesetzt werden, um das maleierte Polymerkohlenwasserstoff(meth)acrylat zu bilden.

3. Verfahren nach Anspruch 1 oder 2, bei dem das Polymer carboxylhaltiges Polybutadien umfaßt, der Reaktant Glycidylmethacrylat und das Maleierungsmittel Maleinsäureanhydrid ist.

4. Verfahren nach Anspruch 1 oder 2, bei dem das Polymer epoxidiertes Polybutadien umfaßt, der Reaktant Glycidylmethacrylat ist und das Maleierungsmittel Maleinsäureanhydrid ist.

5. Verfahren nach Anspruch 1, bei dem das hergestellte Prepolymer die Formel 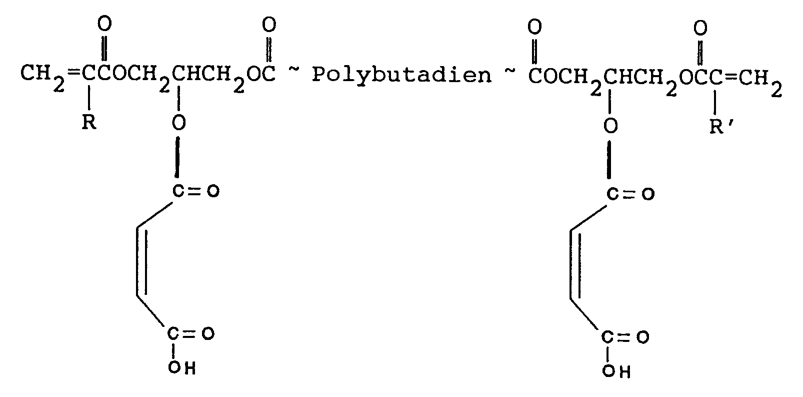 aufweist, wobei R und R' jeweils CH₃ sind.

6. Verfahren, das eine Photopolymerzusammensetzung liefert, die ein flüssiges Prepolymer und 0,01 bis 5 Gew.% eines Photoinitiators umfaßt, dadurch gekennzeichnet, daß das Prepolymer ein Polymer gemäß einem der Ansprüche 1 bis 5 hergestellt worden ist.

7. Verfahren nach Anspruch 6, das eine Zusammensetzung liefert, die zusätzlich bis zu 90 Gew.% eines reaktiven Acryl- oder Methacrylverdünnungsmittels enthält.

8. Verfahren nach Anspruch 6 oder Anspruch 7, das eine Zusammensetzung liefert, die bis zu 50 Gew.% eines inerten transparenten Füllstoffs enthält.

9. Verfahren zum Herstellen eines Photopolymerelements, das einen Träger und eine Photopolymerzusammensetzung umfassende Schicht umfaßt, dadurch gekennzeichnet, daß bei dem Verfahren eine Zusammensetzung gemäß Anspruch 6, Anspruch 7 oder Anspruch 8 geliefert und eine Schicht aus der Zusammensetzung auf den Träger aufgebracht wird.

10. Verfahren zur Herstellung einer durch Wärme härtbaren Zusammensetzung, bei dem eine Zusammensetzung geliefert wird, die ein flüssiges Prepolymer, das nach einem Verfahren gemäß einem der Ansprüche 1 bis 5 hergestellt worden ist, und einen Thermoinitiator umfaßt.

11. Verfahren nach Anspruch 10, das eine Zusammensetzung liefert, die zusätzlich bis zu 90 Gew.% eines reaktiven Acryl- oder Methacrylverdünnungsmittels enthält.

12. Verfahren nach Anspruch 10 oder 11, bei dem eine Zusammensetzung geliefert wird, die zusätzlich bis zu 50 Gew.% eines inerten Füllstoffs enthält.

13. Verfahren nach einem der Ansprüche 1 bis 5, bei dem in einer zusätzlichen Stufe das Polymer gehärtet wird.

14. Verfahren zum Herstellen einer Reliefdruckplatte, bei dem (a) ein Substrat mit einer Schicht aus einer photopolymerisierbaren Zusammensetzung gemäß einem der Ansprüche 6 bis 8 beschichtet wird, (b) die Schicht bildmäßig aktinischer Strahlung ausgesetzt wird, um eine Vernetzung der Zusammensetzung in den belichteten Gebieten zu bewirken, und (c) nicht belichtete Bereiche der Zusammensetzung durch Waschen mit einer wäßrigen Tensidlösung entfernt werden.

15. Verfahren nach Anspruch 14, bei dem die Reliefdruckplatte nach dem Waschen mit aktinischer Strahlung nachbelichtet wird.

## Revendications (Revendications pour l'(les) Etat(s) contractant(s) suivant(s): AT, BE, CH, DE, FR, GB, GR, IT, LI, LU, NL, SE)

1. Prépolymère liquide durcissable sous l'effet de la chaleur ou d'un rayonnement, ayant la formule P(Y)ₐ, où P est un résidu d'un polymère hydrocarboné choisi parmi l'ensemble de polymères comprenant les homopolymères du butadiène, de l'isoprène et du chloroprène, les copolymères butadiène-acrylonitrile, butadiène-isoprène, butadiène-styrène, éthylène-néohexène, butadiène-acide acrylique, les terpolymères butadiène-acrylonitrile-acide acrylique et les composés polymères hydrogénés correspondant à tous les composés ci-dessus, a est supérieur à 1, Y est un groupe directement fixé à P, pouvant être l'un des groupes ayant la structure suivante: 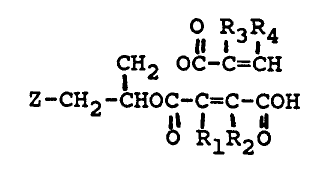 où Z est -NR, 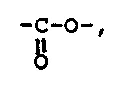 -O- ou -S- et R est H ou un groupe alkyle linéaire ou cyclique ayant de 1 à 6 atomes de carbone, R₁ et R₂, indépendamment l'un de l'autre, sont chacun un radical choisi parmi l'ensemble comprenant H, les halogènes, les radicaux carboxy, alkyle linéaires ou cycliques ayant de 1 à 20 atomes de carbone, aryle, alkaryle et aralkyle ayant de 6 à 20 atomes de carbone, R₃ est H, CH₃ou CH₂COOR₅, R₄ est H, CH₃ ou COOR₆, et R₅ et R₆ sont chacun H ou un radical alkyle ayant 1 ou 2 atomes de carbone.

2. Prépolymère selon la revendication 1, que l'on obtient par la réaction des groupes carboxyles terminaux se trouvant sur le polymère hydrocarboné avec du (méth)acrylate de glycidyle, pour obtenir un intermédiaire hydrocarboné polymère à terminaison (méth)acrylate ayant des groupes hydroxyles latéraux, ces groupes latéraux étant mis à réagir avec l'anhydride maléique.

3. Prépolymère selon la revendication 1, ayant la formule suivante 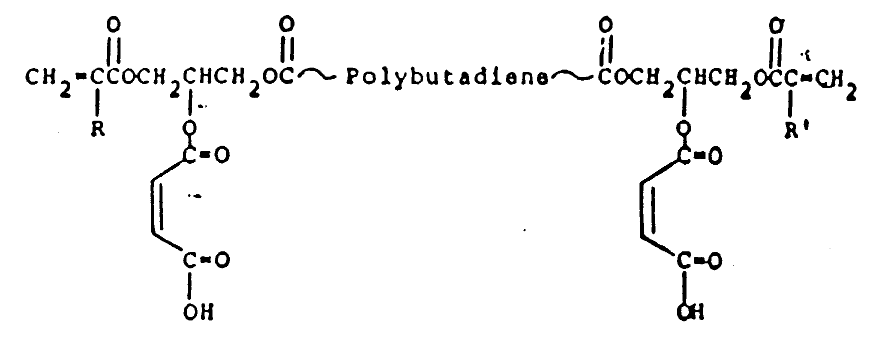 dans laquelle R et R' sont chacun CH₃.

4. Composition photopolymère comprenant un prépolymère liquide et de 0,01 à 5 % en poids d'un photoamorceur, caractérisée en ce que le prépolymère est un polymère selon l'une quelconque ds revendications 1 à 3.

5. Composition selon la revendication 4, contenant en outre jusqu'à 90 % en poids d'un diluant acrylique ou méthacrylique réactif.

6. Composition selon la revendication 4 ou 5, qui contient jusqu'à 50 % en poids d'une charge transparente inerte.

7. Elément photopolymère comprenant un support et une couche comprenant une composition photopolymère, caractérisé en ce que le composition est une composition selon les revendications 4, 5 ou 6.

8. Composition durcissable à la chaleur, comprenant un prépolymère liquide et un amorceur thermique, caractérisée en ce que le prépolymère est un polymère selon l'une quelconque des revendiactions 1 à 3.

9. Composition selon la revendication 8, contenant en outre jusqu'à 90 % en poids d'un diluant acrylique ou méthacrylique réactif.

10. Composition selon la revendication 8 ou 9, contenant en outre jusqu'à 50 % en poids d'une charge inerte.

11. Produit comprenant un prépolymère durci selon l'une quelconque des revendications 1 à 3.

12. Plaque d'impression obtenue par photodurcissement, selon l'image, d'un élément selon la revendication 7.

13. Procédé pour préparer un (méth)acrylate hydrocarboné polymère maléaté, qui consiste à former un (méth)acrylate hydrocarboné polymère en faisant réagir un polymère choisi parmi les homopolymères du butadiène, de l'isoprène et du chloroprène, les copolymères butadiène-acrylonitrile, butadiène-isoprène, butadiène-styrène, éthylène-néohexène, butadiène-acide acrylique, les terpolymères butadiène-acrylonitrile-acide acrylique, et les composés hydrogénés polymères correspondant à tous les composés ci-dessus, ces composés polymères contenant des groupes fonctionnels terminaux choisis parmi l'ensemble comprenant les groupes carboxyle, amine, hydroxyle, thiol et oxyranne, avec un composé contenant un radical (méth)acrylique fonctionnalisé, la fonctionnalité de ce composé correspondant à un radical choisi parmi l'ensemble comprenant les radicaux carboxyle et oxyranne, et pouvant réagir avec les groupes fonctionnels terminaux du composé polymère, la réaction étant mise en oeuvre à une température comprise entre 25 et 200°C, pour donner un hydrocarbure polymère à terminaison (méth)acrylate ayant des groupes hydroxyle latéraux, puis à faire réagir les groupes hyroxyle latéraux se trouvant sur le (méth)acrylate hydrocarboné polymère avec un élément de l'ensemble choisi parmi les anhydrides insaturés de formule générale 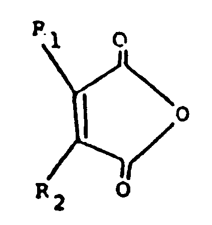 dans laquelle R₁ et R₂, indépendamment l'un de l'autre, sont chacun un radical choisi parmi l'ensemble comprenant H, les radicaux halogène, carboxyle, alkyle linéaire ou cyclique ayant de 1 à 20 atomes de carbone, aryle, alkaryle et aralkyle ayant de 6 à 20 atomes de carbone, et les diesters et diacides correspondants, à une température comprise entre 60 et 120°C pour former le (méth)acrylate hydrocarboné polymère maléaté.

14. Procédé selon la revendication 13, dans lequel le polymère comprend un polybutadiène carboxylé, le composé contenant un radical (méth)acrylique fonctionnalisé est le méthacrylate de glycidyle et l'anhydride insaturé est l'anhydride maléique

15. Procédé selon la revendication 13, le polymère comprend un polybutadiène époxydé, le composé contenant un radical (méth)acrylique fonctionnalisé est l'acide méthacrylique, et l'anhydride insaturé est l'anhydride maléique.

16. Procédé pour former une plaque d'impression en relief, comprenant les étapes consistant :
(a) à appliquer sur un substrat une couche d'une composition photopolymérisable selon l'une quelconque des revendications 4 à 6,
(b) à exposer selon l'image la couche à un rayonnement actinique pour provoquer la réticulation de la composition dans les zones exposées, et
(c) à enlever les zones non exposées de la composition, par lavage avec une solution aqueuse d'un détergent.

17. Procédé selon la revendication 16, qui consiste en outre à procéder à une post-exposition de la plaque d'impression en relief à un rayonnement actinique après le lavage.

## Revendications (Revendications pour l'(les) Etat(s) contractant(s) suivant(s): ES)

1. Procédé pour préparer un prépolymère liquide durcissable sous l'effet de la chaleur ou d'un rayonnement, ayant la formule P(Y)ₐ, où P est un résidu d'un polymère hydrocarboné choisi parmi l'ensemble de polymères comprenant les homopolymères du butadiène, de l'isoprène et du chloroprène, les copolymères butadiene-acrylonitrile, butadiène-isoprène, butadiène-styrène, éthylène-néohexène, butadiène-acide acrylique, les terpolymères butadiène-acrylonitrile-acide acrylique et les composés polymères hydrogénés correspondant à tous les composés ci-dessus, a est supérieur à 1, Y est un groupe directement fixé à P, pouvant être l'un des groupes ayant la structure suivante: 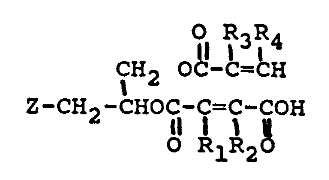 où Z est -NR, 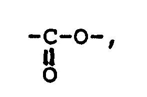 -O- ou -S- et R est H ou un groupe alkyle linéaire ou cyclique ayant de 1 à 6 atomes de carbone, R₁ et R₂, indépendamment l'un de l'autre, sont chacun un radical choisi parmi l'ensemble comprenant H, les halogènes, les radicaux carboxy, alkyle linéaires ou cycliques ayant de 1 à 20 atomes de carbone, aryle, alkaryle et aralkyle ayant de 6 à 20 atomes de carbone, R₃ est H, CH₃ou CH₂COOR₅, R₄ est H, CH₃ ou COOR₆, et R₅ et R₆ sont chacun H ou un radical alkyle ayant 1 ou 2 atomes de carbone, qui comprend une première étape, dans laquelle un polymère hydrocarboné liquide fonctionnalisé est mis à réagir avec un réactif destiné à lui donner des groupes (méth) acrylates, et une deuxième étape dans laquelle le polymère hydrocarboné liquide à fonctionnalité (méth)acrylate est soumis à une maléation par réaction avec un agent de maléation.

2. Procédé selon la revendication 1, qui consiste à préparer un (méth)acrylate hydrocarboné polymère maléaté, qui consiste à former un (méth)acrylate hydrocarboné polymère en faisant réagir un polymère choisi parmi les homopolymères du butadiène, de l'isoprène et du chloroprène, les copolymères butadiène-acrylonitrile, butadiène-isoprène, butadiène-styrène, éthylène-néohexène, butadiène-acide acrylique, les terpolymères butadiène-acrylonitrile-acide acrylique, et les composés hydrogénés polymères correspondant à tous les composés ci-dessus, ces composés polymères contenant des groupes fonctionnels terminaux choisis parmi l'ensemble comprenant les groupes carboxyle, amine, hydroxyle, thiol et oxyranne, avec un composé contenant un radical (méth)acrylique fonctionnalisé, la fonctionnalité de ce composé correspondant à un radical choisi parmi l'ensemble comprenant les radicaux carboxyle et oxyranne, et pouvant réagir avec les groupes fonctionnels terminaux du cmposé polymère, la réaction étant mise en oeuvre à une température comprise entre 25 et 200°C, pour donner un hydrocarbure polymère à terminaison (méth)acrylate ayant des groupes hydroxyle latéraux, puis à faire réagir les groupes hyroxyle latéraux se trouvant sur le (méth) acrylate hydrocarboné polymère avec un élément de l'ensemble choisi parmi les anhydrides insaturés de formule générale 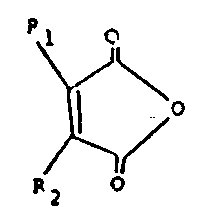 dans laquelle R₁ et R₂, indépendamment l'un de l'autre, sont chacun un radical choisi parmi l'ensemble comprenant H, les radicaux halogène, carboxyle, alkyle linéaire ou cyclique ayant de 1 à 20 atomes de carbone, aryle, alkaryle et aralkyle ayant de 6 à 20 atomes de carbone, et les diesters et diacides correspondants, à une température comprise entre 60 et 120°C pour former le (méth)acrylate hydrocarboné polymère maléaté.

3. Procédé selon la revendication 1 ou 2, dans lequel le polymère comprend un polybutadiène carboxylé, le réactif est le méthacrylate de glycidyle et l'agent de maléation est l'anhydride maléique.

4. Procédé selon la revendication 1 ou 2, dans lequel le polymère comprend un polybutadiène époxydé, le réactif est l'acide méthacrylique et l'agent de maléation est l'anhydride maléique.

5. Procédé selon la revendication 1, dans lequel le prépolymère produit a la formule 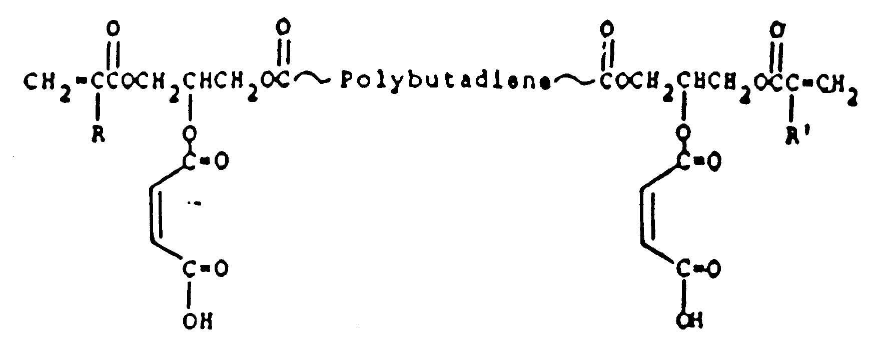 dans laquelle R et R' sont chacun CH₃.

6. Procédé qui consiste à fournir une composition photopolymère comprenant un prépolymère liquide et de 0,01 à 5 % en poids d'un photo-amorceur, caractérisé en ce que le prépolymère est préparé par un procédé selon l'une quelconque des revendications 1 à 5.

7. Procédé selon la revendication 6, qui consiste à fournir une composition contenant en outre jusqu'à 90 % en poids d'un diluant acrylique ou méthacrylique réactif.

8. Procédé selon la revendication 6 ou 7, qui consiste à fournir une composition contenant jusqu'à 50 % en poids d'une charge transparente inerte.

9. Procédé pour former un élément photopolymère comprenant un support et une couche comprenant une composition photopolymère, le procédé consistant à fournir une composition selon la revendication 6, 7 ou 8 et à appliquer sur le support une couche de la composition.

10. Procédé pour préparer une composition durcissable à la chaleur, qui consiste à fournir une composition comprenant un prépolymère liquide préparé par un procédé selon l'une quelconque des revendications 1 à 5, et un amorceur thermique.

11. Procédé selon la revendication 10, qui consiste à fournir une composition contenant en outre jusqu'à 90 % en poids d'un diluant acrylique ou méthacrylique réactif.

12. Procédé selon la revendication 10 ou 11, qui consiste à fournir une composition contenant en outre jusqu'à 50 % en poids d'une charge inerte.

13. Procédé selon l'une quelconque des revendications 1 à 5, qui comprend l'étape supplémentaire consistant à durcir le polymère.

14. Procédé pour former une plaque d'impression en relief, comprenant les étapes consistant :
(a) à appliquer sur un substrat une couche d'une composition photopolymérisable selon l'une quelconque des revendications 6 à 8,
(b) à exposer selon l'image la couche à un rayonnement actinique pour provoquer la réticulation de la composition dans les zones exposées, et
(c) à enlever les zones non exposées de la composition, par lavage avec une solution aqueuse d'un détergent.

15. Procédé selon la revendication 14, qui consiste en outre à procéder à une post-exposition de la plaque d'impression en relief à un rayonnement actinique après le lavage.
